# EUROPÄISCHE PATENTSCHRIFT

(11) **EP 1 093 229 B1**
(45) Veröffentlichungstag und Bekanntmachung des Hinweises auf die Patenterteilung: **14.06.2006**
(21) Anmeldenummer: 00890303.1
(22) Anmeldetag: 06.10.2000
(51) Int. Cl.: H03M 1/06, H03M 1/80, H03M 1/46

(54) **Differentieller Analog-Digitalwandler**
Differential analogue-to-digital converter
Convertisseur analogique-numérique différentiel

(30) Priorität: 15.10.1999 AT 71699 U
(43) Veröffentlichungstag der Anmeldung: 18.04.2001
(73) Patentinhaber: AUSTRIA MIKRO SYSTEME INTERNATIONAL AKTIENGESELLSCHAFT, A-8141 Unterpremstätten (AT)
(72) Erfinder: Promitzer, Gilbert, Dipl.-Ing., 8480 Mureck (AT)
(74) Vertreter: Haffner, Thomas M.

(56) Entgegenhaltungen:
- US-A- 4 803 462
- US-A- 4 831 381
- US-A- 5 920 275
- HESTER R K ET AL: "FULLY DIFFERENTIAL ADC WITH RAIL-TO-RAIL COMMON-MODE RANGE AND NONLINEAR CAPACITOR COMPENSATION" IEEE JOURNAL OF SOLID-STATE CIRCUITS, IEEE INC. NEW YORK, US, Bd. 25, Nr. 1, 1. Februar 1990 (1990-02-01), Seiten 173-182, XP000101865 ISSN: 0018-9200

## Beschreibung

Die Erfindung bezieht sich auf einen differentiellen Analog-Digitalwandler mit geschalteten Kapazitäten und sukzessiver Approximation, bei welchem ein Komparator mit den Kapazitäten verbunden ist und binär gewichtete als Arrays geschaltete Kapazitäten bezüglich der Messeingänge und der Anschlüsse an den Komparator symmetrisch angeordnet sind.

Ein derartiger Analog-Digital-Wandler ist beispielsweise aus der US-A-4,831,381 oder der US-A-4,803,462 bekannt geworden.

Analog-Digitalwandler sind in unterschiedlicher Ausbildung bekannt. Derartige Analog-Digitalwandler (ADC) sind in spezieller Ausbildung, beispielsweise für die Digitalisierung von Spannungsmesswerten, unter Verwendung von Kondensatoren aufgebaut, wobei derartige ADCs üblicherweise auf der Basis von kapazitätsbasierten Digital-Analogwandlern aufgebaut sind, welche üblicherweise als CDAC bezeichnet werden. Die Ausgänge derartiger CDACs werden mit dem Eingang eines Komparators verbunden. Die bekannten Schaltungskonzepte können unipolar oder bipolar aufgebaut sein, wobei der Wandlungsbereich von einer Reihe von Faktoren abhängig ist. Die zum Einsatz gelangenden Komparatoren zeichnen sich dadurch aus, dass sie nur über einen bestimmten Spannungsbereich verzerrungsfrei und völlig linear arbeiten. Dieser sog. Common Mode Range (CMR), über welchen eine Linearauflösung gewährleistet ist, erstreckt sich über einen Bereich von Eingangsspannungen, welche von der Schaltungsanordnung gewährleistet sein müssen. Die hiefür eingeführte Größe ist die sog. Common Mode Voltage (CMV), von welcher ausgehend in einem definierten Bereich störungsfreie Wandlerergebnisse gewährleistet sind.

ADC, welche auf der Basis von CDACs aufgebaut sind, können entweder ein einzelnes analoges Eingangssignal oder kontinuierlich differentielle Eingangssignale erfassen und werden daher als "single-ended" oder "differentiell" klassifiziert. Bei einer differentiellen ADC-Archtitektur sind zwei parallele CDACs vorgesehen, wobei einer dieser CDACs üblicherweise mit dem positiven Eingang des Komparators und der andere CDAC mit dem negativen Eingang des Komparators verbunden ist. Der Messbereich setzt eine entsprechende Mehrzahl von Kapazitäten, welche dual gewichtet angeordnet sein müssen, voraus, wobei je nach gewünschter Auflösung eine entsprechende Anzahl von relativ großen Kapazitäten vorgesehen sein muss und eine entsprechende Auflösung ein relativ hohes Verhältnis der Kapazität des Kondensators für das most significant bit (MSB) zur Kapazität des least significant bits (LSB) erfordert. Die duale Gewichtung setzt voraus, daß die einzelnen Kapazitäten jeweils in Potenzen von zwei vergrößert werden und die Anzahl derartiger Kapazitäten die maximale Auflösung bestimmt. Unter Berücksichtigung der CMR des Komparators kommen weitere Einschränkungen in Betracht.

In der US-A-5 581 252 wird ein Überblick über konventionelle CDAC-Archtitektur geboten. Zur Lösung des Problems der relativ großen Verhältnisse zwischen den einzelnen Kapazitäten wird eine Architektur vorgeschlagen, bei welcher ein DAC als Main-DAC dient und der andere DAC als Sub-DAC, um die entsprechende Auflösung zu erhöhen und mit einer geringeren Anzahl von Kapazitäten das Auslangen zu finden. In diesem Sinne ist der Vorschlag gemäß der US-A-5 581 252 nicht als differentiell symmetrisch anzusehen, wodurch sich eine Reihe von Fehlern ergeben können, welche insbesondere beim Öffnen des Sampling-Schalters durch die hiebei auftretenden Ausschaltspannungsspitzen verursacht werden. Nur bei völlig symmetrischem differentiellen Aufbau gelingt es derartige Chargeinjectionfehler auszumitteln, sodass sie die Messwerte nicht weiter verzerren.

Eine Erhöhung der Auflösung kann durch Nachschaltung eines Sub-DAC, der an die LSB-Cap angeschlossen wird und eine Interpolation des LSB des Main-DAC durchführt, erzielt werden. Das hat keinen nachteiligen Effekt auf die Symmetrie der Gesamtschaltung.

Aufgrund der eingangs genannten Schwierigkeiten der wahl eines geeigneten Arbeitsbereiches innerhalb des CMR des Komparators wurde bei den bekannten Einrichtungen, wie sie in der US-A-5 581 252 beschrieben wurden, als CMV das Massepotential der Einrichtung gewählt. Das Massepotential elektronischer Baugruppen ist dabei in hohem Maße von Störeinflüssen und Einstreuungen beeinträchtigt, sodass eine derartige Mittenreferenz für den gewünschten CMV-Wert zu einer Reihe weiterer Verzerrungen Anlass geben kann. Um dieses Problem zu vermeiden wurde auch bereits vorgeschlagen, bei differentiellen ADC-Architekturen die beiden Anschlüsse für die Eingangsspannung an einen Spannungsteiler zu führen, an welchem die Messspannung über Widerstände abfällt und an einem Mittenabgriff eine CMV abgegriffen werden kann. Wenn diese CMV als Referenzspannung für beide symmetrischen CDACs zum Einsatz gelangt, kann zwar die Stabilität der Auswertung verbessert werden, wobei mit einer derartigen Schaltungsanordnung allerdings der wesentliche Nachteil verbunden ist, dass der Eingangsspannungsteil die zu messende Spannungsquelle in hohem Maße belastet. Während die Eingänge des Komparators als überaus hochohmig angesehen werden können, führt ein derartiger Spannungsteiler zu einem entsprechenden Spannungsabfall an dem Eingangswiderstand, sodass die Empfindlichkeit wesentlich verringert wird. Die über einen derartigen Spannungsteiler erzielte Pufferung ist somit nicht nur in hohem Maße stromverbrauchend, sondern wirkt sich auch in der Folge auf die jeweilige Ladezeit der Kapazität der einzelnen CDACs nachteilig aus, sodass die Samplingrate auf diese Weise wesentlich limitiert wird. Für Samplingraten in höheren Frequenzbereichen sind derartige Schaltungsanordnungen daher prinzipiell ungeeignet.

Die Erfindung zielt nun darauf ab, einen differentiellen Analog-Digitalwandler mit geschalteten Kapazitäten und sukzessiver Approximation der eingangs genannten Art zu schaffen, mit welchem bei geringster Belastung der Messspannungsquelle und hohen Samplingraten eine entsprechend gute Auflösung und gleichzeitig eine gute konstante Arbeitsweise des Komparators sichergestellt werden kann. Zu diesem Zweck ist die erfindungsgemäße Ausbildung im wesentlichen dadurch gekennzeichnet, dass Schalter für die Gleichladung bzw. Kurzschlussentladung aller Kapazitäten vor der Einleitung einer Trackphase angeordnet sind, dass ein Sample-Block-Schalter in der Trackphase geschlossen ist und die komparatorseitigen Anschlüsse der Kapazitätsarrays unmittelbar miteinander verbindet, sodass die symmetrisch angeordneten Kapazitätsarrays in Serie geschaltet mit den Messeingängen verbunden sind, dass in der Phase der sukzessiven Approximation jede Kapazität wahlweise mit jeweils einer der Referenzspannungsquellen über Schalter verbindbar ist und dass die sukzessive Approximation symmetrisch zur aus den Referenzspannungen resultierenden CMV (Common Mode Spannung) ausgelegt ist. Zu Beginn eines Messzyklus muss naturgemäß zunächst ein Entlade- oder Gleichladevorgang vorgenommen werden, für welchen unterschiedliche und teilweise bekannte Maßnahmen zur Verfügung stehen. Eine vollständige Entladung kann naturgemäß nur dann erfolgen, wenn die Eingänge abgetrennt sind, wobei eine vollständige Entladung naturgemäß am einfachsten durch Kurzschluss erzielt wird. Im Fall der Verwendung von Dämpfungskapazitäten kann bei abgetrenntem Eingang aber auch eine Gleichladung vorgenommen werden, wobei alle Kapazitäten auf dem gleichen Ladungszustand durch Parallelschaltung gebracht werden. Was die Samplingrate anlangt, ergeben sich je nach gewählter Entladung oder Umladung naturgemäß unterschiedliche Ladezeiten, wobei bei einer Gleichladung durch Parallelschaltung die Kapazitäten im schlimmsten Fall um die halbe Referenzspannung von der Quelle umgeladen werden müssen, wodurch die Belastung der Quelle am Eingang gegenüber einer vollständigen Entladung um die Hälfte reduziert werden kann.

In der nachfolgenden Trackphase werden die beiden Kapazitätsarrays in Serie geschaltet und jeweils an je eine Eingangsspannung gelegt. Die möglicherweise vorhandenen Dämpfungskondensatoren können an zwei Referenzspannungen gelegt werden. Zu diesem Zweck stehen zwei von einander verschiedenen Referenzspannungen Vref N und Vref P zur Verfügung, welche bei der erfindungsgemäßen Einrichtung in weiten Bereichen frei gewählt werden können. Der durch Spannungsänderungen am Eingang verursachte Spannungsabfall aufgrund der in der Trackphase vorliegenden Serienschaltung sind in beiden Arrays gleichzeitig gespeichert, wobei die Spannungquelle am Eingang nur die halbe Kapazität aufgrund der Serienschaltung sieht. Bei der gewählten Schaltungsanordnung wird zum Unterschied von bekannten Lösungen kein Puffer zur Umladung der Kapazitätsarrays benötigt, wodurch der Energieverbrauch der Messschaltung wesentlich verringert werden kann. Der Eingangsbereich für den Komparator wird auf einen sich aus der Wahl der beiden Referenzspannungen ergebenden Bereich beschränkt, wobei bei gleichbleibender Eingangsspannung die Quelle nicht belastet wird. Der Schalter für die Serienschaltung der beiden symmetrischen CDACs verursacht naturgemäß im Komparator einen entsprechenden Spannungsabfall, welcher in den Off setkapazitäten des Komparators gespeichert und damit kompensiert werden kann. Bei einem Öffnen dieses Schalters, welcher nachfolgend als Samplingschalter oder Sample-Block-Schalter bezeichnet wird, beginnt das Sampling bzw. die sukzessive Approximation, wobei die beim Öffnen erzeugte Chargeinjection sich nahezu gleichmäßig auf die beiden Arrays aufteilt und auf diese Weise keinen relevanten Fehler verursacht. Der Sample-Block kann auch aus mehreren Schaltern bestehen, wobei ein Schalter als Sample-Schalter dient und die restlichen Schalter die Komparator-Eingänge während der Track-Phase vom Cap-Array abtrennen und auf das Common Mode Potential der Referenzspannungen legen. Dadurch wird auch die Common Mode Spannung des Eingangssignals in weiten Grenzen frei wählbar.

In der nachfolgenden Phase der sukzessiven Approximation, in welcher der Sample-Block-Schalter geöffnet wird, wird die in den Kapazitätsarrays gespeicherte Ladung in den äquivalenten digitalen Wert umgewandelt, wobei je nach zuvor gespeicherter Eingangsspannung die einzelnen Kapazitäten mittels jeweils gesonderter Schalter mit Vref P oder Vref N verbunden werden. Bei einer derartigen sukzessiven Approximation wird in bekannter Weise das analoge Signal in n-Schritten in einen digitalen Code mit n-Bits verwandelt. Das analoge Signal wird jeweils mit dem CDAC-Ausgang verglichen, um den digitalen Code zu bestimmen, wobei die Bestimmung in der Regel mit dem most significant bit (MSB) beginnt und fortgeführt wird, bis das last significant bit (LSB) bestimmt ist. In jedem dieser sukzessiven Vergleichssahritten wird das analoge Signal mit dem CDAC-Ausgang, wie er aus dem zuvor approximierten Bit resultiert und dem Bit, das jeweils gerade getestet wird, verglichen, wobei das gegenwärtige Bit solange auf logisch 1 gesetzt bleibt, solange der CDAC-Ausgang kleiner ist als das analoge Signal.

Gemäß der Erfindung ist die Ausbildung so getroffen, dass der Sample-Block-Schalter in der Trackphase geschlossen ist und die komparatorseitigen Anschlüsse der Kapazitätsarrays unmittelbar miteinander verbindet, sodass die symmetrisch angeordneten Kapazitätsarrays in Serie geschaltet mit den Messeingänqen verbunden sind. Dadurch, dass abweichend von den Ausbildungen gemäß dem Stand der Technik der Samplingschalter in der Trackphase die Kapazitätsarrays unmittelbar miteinander verbindet, ohne dass dieser Schalter an gemeinsamer Masse liegt, werden für die Messung lediglich die nunmehr in Serie geschalteten Kapazitätsarrays sichtbar, welche gegen das sich aus den Referenzspannungen ergebende Potential geladen werden. Die Referenzspannungen können hiebei, zum Unterschied von der gemeinsamen Masse derartiger Einrichtungen, weitestgehend frei von Störungen gehalten werden, sodass Verzerrungen nicht befürchtet werden müssen.

In besonders bevorzugter Weise ist die Ausbildung so getroffen, dass die komparatorseitigen Anschlüsse der Kapazitätsarrays in der Trackphase und der Phase der sukzessiven Approximation mit jeweils einer Referenzspannungsquelle unter Zwischenschaltung von Dämpfungskondensatoren über Schalter verbindbar sind. In der Trackphase ist der Sample-Block-Schalter geschlossen, wohingegen in der Phase der sukzessiven Approximation dieser Schalter zum Zwecke des Samplings geöffnet wird. Die Schaltungsanordnung erlaubt es hiebei insbesondere auch die erforderlichen Schalter entsprechend einfach aufzubauen, wobei mit Vorteil die Ausbildung so getroffen ist, dass die Schalter zu Mehrfach-T-Gates, insbesondere Vierfach-T-Gates, als Arrays parallel - geschaltet aufgeteilt und angeordnet sind. Durch die Parallelschaltung derartiger Schalter werden die Nachteile, wie sie mit einer Serienschaltung von T-Gates verbunden sind, vermieden und es können die in den einzelnen Phasen der Wandlung erforderlichen Schalterstellungen von einer üblichen Steuerlogik unmittelbar angesteuert werden.

Bei den obigen Betrachtungen wurden die bei differentiellen Analog-Digitalwandlern bekannten Bauteile, wie beispielsweise der im Komparator üblicherweise integrierte Latch sowie die Steuerelektronik für die Betätigung der Schalter in den einzelnen Phasen des Trackings sowie der sukzessiven Approximation nicht näher betrachtet, da diese bei derartigen Schaltungen in konventioneller Weise und insbesondere beispielsweise in der in der US-A-5 581 252 vorgesehenen Weise verwirklicht sein können.

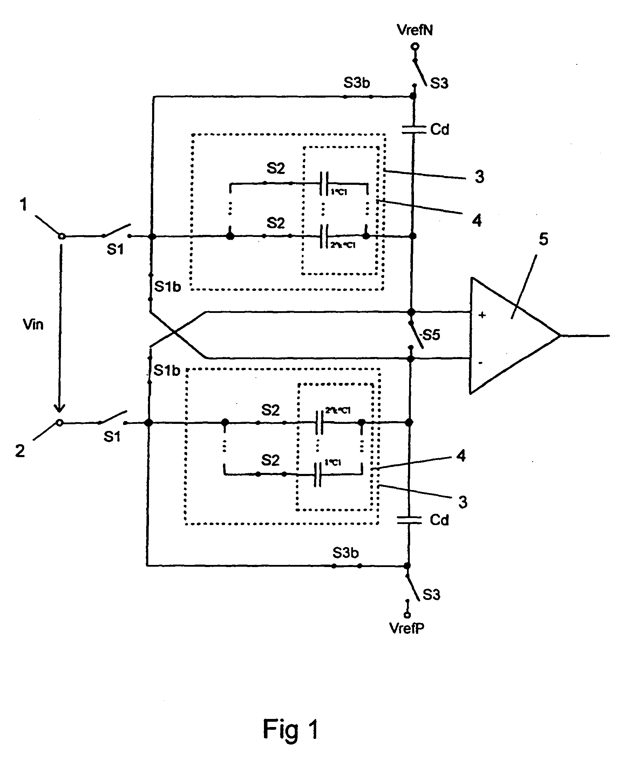

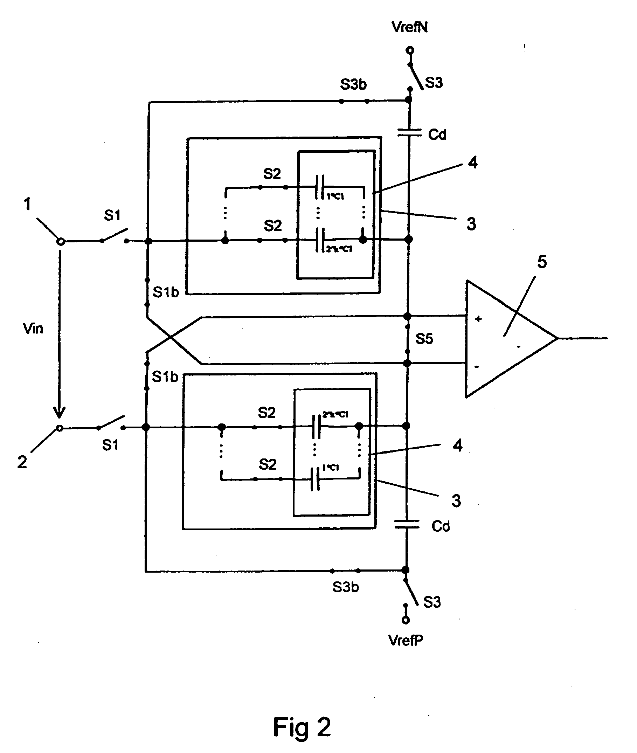

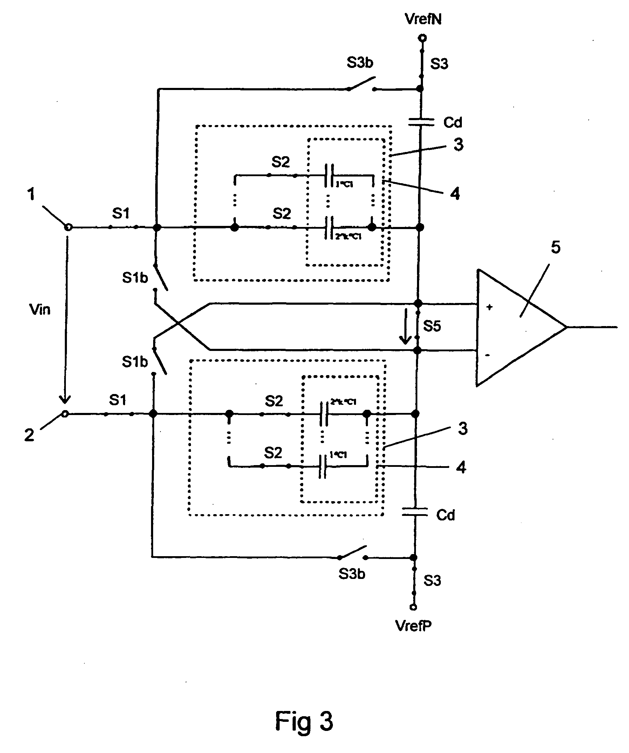

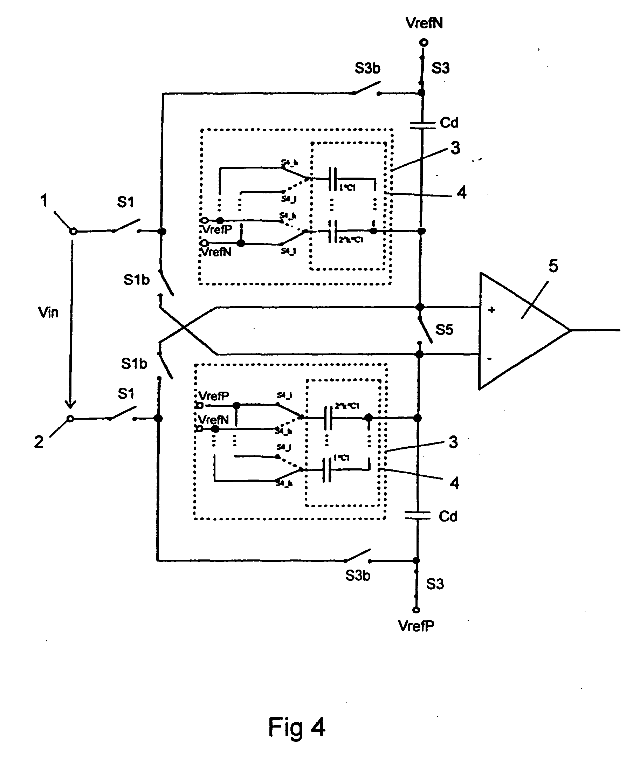

Die Erfindung wird nachfolgend anhand eines in der Zeichnung schematisch dargestellten Ausführungsbeispieles näher erläutert. In dieser zeigen Fig. 1 die Schaltungsanordnung für die Entladung aller Kapazitäten, Fig. 2 die Schaltungsanordnung entsprechend der Fig. 1, bei welcher eine Umladung bzw. Gleichladung der Kapazitäten vorgenommen wird, Fig. 3 die Schalteranordnung innerhalb der Schalter während der Trackphase und Fig. 4 die Schalterstellungen in der Phase der sukzessiven Approximation.

In Fig. 1 sind die Anschlüsse für die Meßspannung mit 1 und 2 bezeichnet, wobei an diesen Anschlüssen die Meßspannung Vin anliegt. Die Anschlüsse sind über Schalter S1 von den CDACs 3 trennbar, wobei diese Schalter geöffnet sein müssen, wenn die Kapazitäten C1 ... 2^{k}C1 entladen oder umgeladen werden. In Fig. 1 erfolgt die Entladung durch Parallelschaltung der beiden Kapazitätsarrays 4 mit der Dämpfungskapazität Cd, wodurch alle Kapazitäten gleich aufgeladen werden. Zu diesem Zweck sind die Schalter S1 geöffnet, die Schalter S2 geschlossen und während der Umladung auch der Sample-Block-Schalter S5 geöffnet. Die beiden Refenzspannungen Vref N und Vref P werden gleichfalls durch Schalter S3 von der Schaltungsanordnung getrennt, wobei zum Zwecke der Parallelschaltung inklusive der Dämpfungskapazitäten Cd die Schalter S1b und S3b geschlossen sind. Durch Schließen des Schalters S5, d.h. des Sample-Block-Schalters, wie dies in Fig. 2 dargestellt ist, wird ersichtlich, daß nun eine Kurzschlußentladung möglich ist, wobei die Schalter S1 und S3 offen bleiben und die Schalter S1b, S3b, S2 und S5 geschlossen sind. Der Komparator, an dessen beiden Eingängen jeweils die Ausgänge der Kapazitätsarrays angeschaltet sind, ist hiebei mit 5 bezeichnet und enthält die erforderlichen Speicherbausteine bzw. Latches. In der Zeichnung sind die einzelnen Kapazitäten der Kapazitätsarrays mit Cl bzw. Vielfachen von Cl angegeben und jeweils über gesonderte Schalter angesteuert, welche selbst wiederum als Array aufgeteilt sind, wodurch im DAC 3 Dreifach-T-Gates entstehen. Durch ein mögliches Integrieren der Schalter S1 und S1b im Schalter Array von DAC 3 entstehen Vierfach-T-Gates.

In der Trackingphase, wie sie in Fig. 3 schematisch ersichtlich ist, werden nun die Schalter S1b und S3b geöffnet, sodaß die Eingangsspannung nach Schließen der Schalter S1 und S3 ebenso wie die sich aus den beiden Referenzspannungen ergebende Spannung an die Kapazitätsarrays 4 angelegt wird. Die am Eingang anliegende Spannung wird je zur Hälfte in den beiden symmetrischen Kapazitätsarrays 4 gespeichert, wobei der durch Spannungsänderungen am Eingang verursachte Spannungsabfall über den Schalter S5 in den im Komparator 5 enthaltenen Kapazitäten gespeichert wird, wodurch dieser Spannungsabfall kompensiert wird. Zur Umladung wird somit kein Puffer benötigt, und bei gleichbleibender Eingangspannung wird die Quelle (Vin) nicht belastet. Die am Schalter S5 abfallende Spannung wird in den im Komparator 5 enthaltenen Offsetkapazitäten gespeichert und damit kompensiert, wobei dieser Schalter S5, der Sample-Block-Schalter, beim Öffnen zwar eine Chargeinjection erzeugen kann, die sich allerdings gleichmäßig auf die beiden Arrays 4 aufteilt, und auf diese Weise keinen Fehler verursacht. Aufgrund der Serienschaltung der beiden Kapazitätsarrays 4 sieht die Spannungsquelle am Eingang nur die halbe Kapazität.

In der Fig. 4 wird nun die Phase der sukzessiven Approximation näher verdeutlicht. In dieser Phase wird die in den Kapazitätsarrays 4 gespeicherte Ladung in den äquivalenten digitalen Wert umgewandelt, wobei je nach zuvor gespeicherter Eingangsspannung die einzelnen Kapazitäten mittels der Schalter S41 bzw. S4h mit Vref P oder Vref N verbunden werden. In dieser Phase der sukzessiven Approximation wird die Meßspannung von der Schaltungsanordnung durch Öffnen der Schalter S1 getrennt. Der Sample-Block-Schalter S5 wird für den Samplingvorgang geöffnet, wobei auch die in Fig. 4 nicht gezeigten Schalter S2 geöffnet sind.

Mit der erfindungsgemäßen Schaltungsanordnung kann der Komparator aufgrund der freien Wählbarkeit von Vref P und Vref N auf einen CMV-Wert innerhalb des zulässigen CMR gehalten werden, wobei durch die freie Wählbarkeit von Vref P und Vref N der Meßbereich und damit die Wahl des Wandlungsbereiches beliebig verändert werden kann. Durch die volldifferentielle Schaltung wird ein hohes Maß an Stabilität gegenüber Spannungspitzen bei Schaltvorgängen erzielt und durch den Verzicht auf einen Puffer und einen von der zu messenden Eingangsspannung abgeleiteten CMV-Wert kann die Belastung der zu messenden Spannungsquelle überaus gering gehalten werden. Gleichzeitig kann die Samplingrate wesentlich erhöht werden, da die Ladezeit nicht mehr durch einen derartigen Puffer beschränkt wird. Dadurch, daß auf die gemeinsame Masse als Spannungsreferenzwert verzichtet wird, wird insgesamt die Störungsanfälligkeit herabgesetzt, und dadurch die Empfindlichkeit weiter erhöht.

## Patentansprüche

1. Differentieller Analog-Digitalwandler mit geschalteten Kapazitäten und sukzessiver Approximation, bei welchem ein Komparator (5) mit den Kapazitäten verbunden ist und binär gewichtete als Arrays (4) geschaltete Kapazitäten bezüglich der Messeingänge (1,2) und der Anschlüsse an den Komparator (5) symmetrisch angeordnet sind, **dadurch gekennzeichnet, dass** Schalter (S1b, S3b, S2) für die Gleichladung bzw. Kurzschlussentladung aller Kapazitäten vor der Einleitung einer Trackphase angeordnet sind, dass ein Sample-Block-Schalter (S5) in der Trackphase geschlossen ist und die komparatorseitigen Anschlüsse der Kapazitätsarrays (4) unmittelbar miteinander verbindet, sodass die symmetrisch angeordneten Kapazitätsarrays (4) in Serie geschaltet mit den Messeingängen (1,2) verbunden sind, dass in der Phase der sukzessiven Approximation jede Kapazität wahlweise mit jeweils einer der Referenzspannungsquellen (Vref N, Vref P) über Schalter (S3) verbindbar ist und dass die sukzessive Approximation symmetrisch zur aus den Referenzspannungen resultierenden CMV (Common Mode Spannung) ausgelegt ist.

2. Differentieller Analog-Digitalwandler nach Anspruch 1, **dadurch gekennzeichnet, dass** die komparatorseitigen Anschlüsse der Kapazitätsarrays (4) in der Trackphase und der Phase der sukzessiven Approximation mit jeweils einer Referenzspannungsquelle (Vref N , Vref P) unter Zwischenschaltung von Dämpfungskondensatoren (d) über Schalter (S3) verbindbar sind.

3. Differentieller Analog-Digitalwandler nach Anspruch 1 oder 2, **dadurch gekennzeichnet, dass** die Schalter (S2) zu Mehrfach-T-Gates, insbesondere Vierfach-T-Gates, als Arrays parallel geschaltet aufgeteilt und angeordnet sind.

4. Differentieller Analog-Digitalwandler nach Anspruch 1, 2 oder 3, **dadurch gekennzeichnet, dass** der Sample-Schalter aus mehreren Schaltern besteht, wobei ein Schalter als Sample-Schalter dient und die restlichen Schalter die Komparator-Eingänge während der Track-Phase vom Cap-Array abtrennen und auf das Common Mode Potential der Referenzspannung legen.

## Claims

1. A differential analog-to-digital converter arrangement of the type including switched capacitance means and successive approximation, including a comparator (5) connected to said capacitance means and binary weighted capacitance means connected as arrays (4) being symmetrically arranged relative to the measuring inputs (1,2) and said connections to the comparator (5), **characterized in, that** switches (S1b, S3b, S2) for the common mode charging and the short-circuit discharging of all capacitance means respectively are arranged prior to triggering a track phase, that a sample-block switch (S5) is closed during the track-phase and directly interconnects the connections of the capacitance arrays (4) on the side of the comparator, the symmetrically arranged capacitance arrays (4) being thus switched in series with the measuring inputs (1,2), that during the phase of successive approximation each capacitance is facultatively connectable to each one of the reference-voltage sources (Vref N, Vref P) by switches (S3) and that the successive approximation is symmetrically dimensioned for the CMV (common mode voltage) derived from the reference-voltages.

2. A differential analog-to-digital converter arrangement as set forth in claim 1, **characterized in, that** the connections of the capacitance arrays (4) on the side of the comparator are facultatively connectable by switches (S3) to each one of the reference-voltage sources (Vref N, Vref P) under interposition of attenuation capacitors (d).

3. A differential analog-to-digital converter arrangement as set forth in claims 1 or 2, **characterized in, that** the switches (S2) are parallelly switched as arrays and are subdivided into and arranged as multiple-T-gates and in particular as quadruple-T-gates.

4. A differential analog-to-digital converter arrangement as set forth in claims 1, 2 or 3, **characterized in, that** the sample switch consists of several switches, wherein one switch serves as sample switch and the remaining switches, during the track-phase, separate the comparator inputs from the cap-array and put them on the common mode potential of the reference voltage.

## Revendications

1. Convertisseur analogique-numérique différentiel avec des condensateurs couplés et approximation successive, dans lequel un comparateur (5) est relié aux condensateurs et des condensateurs pondérés de manière binaire et couplés sous la forme d'ensembles (4) sont disposés symétriquement par rapport aux entrées des mesurage (1,2) et aux connexions aux comparateur (5), **caractérisé en ce que** des commutateurs (S1b, S3b, S2) sont prévus pour la charge uniforme ou la décharge de court-circuit de tous les condensateurs avant l'amorce d'une phase de cheminement, en qu'un commutateur sample block (S5) est fermé dans la phase de cheminement et relie entre elles les connexions côté comparateur des ensembles de condensateurs (4), ce qui fait que les ensembles de condensateurs (4), disposés symétriquement, sont reliés en série aux entrées de mesurage (1,2), **en ce qu'**au cours de la phase de l'approximation successive chaque condensateur peut être relié aux choix à l'une des sources de tension de référence (Vref N, Vref P) respective par des commutateurs (S3), et **en ce que** l'approximation successive est conçue symétriquement par rapport à la TMC (Tension à Mode Commun) résultant des tensions de référence.

2. Convertisseur analogique-numérique différentiel selon la revendication 1, **caractérisé en ce que** les connexions côté comparateur des ensembles de condensateurs (4) peuvent être reliés au cours de la phase de cheminement et de la phase de l'approximation successive à une source de tension de référence (Vref N, Vref P) respective, avec interposition de condensateurs d'amortissement (d), par l'intermédiaire de commutateurs (S3).

3. Convertisseur analogique-numérique différentiel selon la revendication 1 ou 2, **caractérisé en ce que** les commutateurs (S2) sont reliés en parallèle sous la forme d'ensembles et divisés et arrangés sous la forme de portes en T multiples, en particulier de portes en T quadruples.

4. Convertisseur analogique-numérique différentiel selon la revendication 1,2 ou 3, **caractérisé en ce que** le commutateur sample est constitué de plusieurs commutateurs, un commutateur servant de commutateur sample et les commutateurs restants séparant les entrées du comparateur de l'ensemble cap, pendant la phase de cheminement, et les reliant au potentiel à Mode Commun de la tension de référence.
